Europäisches Patentamt

European Patent Office

Office européen des brevets

(19)

(11) Publication number: **0 163 074 B1**

## EUROPEAN PATENT SPECIFICATION

(12)

(45) Date of publication of patent specification: **26.06.91**   (51) Int. Cl.⁵: **H01L 21/31**, H01L 21/00

(21) Application number: **85104229.1**

(22) Date of filing: **11.04.85**

(54) **A process for forming via holes having sloping side walls in a polymer film.**

(30) Priority: **21.05.84 US 612189**

(43) Date of publication of application:
**04.12.85 Bulletin 85/49**

(45) Publication of the grant of the patent:
**26.06.91 Bulletin 91/26**

(84) Designated Contracting States:
**DE FR GB**

(56) References cited:
**EP-A- 0 001 038**
**EP-A- 0 010 657**

**IBM TECHNICAL DISCLOSURE BULLETIN, vol.
26, no. 8, January 1984, pages 4280-4281,
New York, US; S.G. CHAPMAN et al.: "Plasma
etching of polyimide through an aluminum
mask"**

(73) Proprietor: **International Business Machines
Corporation
Old Orchard Road
Armonk, N.Y. 10504(US)**

(72) Inventor: **Hiraoka, Hiroyuki
18635 Montewood Drive
Saratoga California 95070(US)**

(74) Representative: **Johansson, Lars E.
IBM Svenska AB Intellectual Property De-
partment 4-01
S-163 92 Stockholm(SE)**

## Description

The present invention relates to a process for forming via holes having sloping sidewalls in a polymer film.

In most lithographic etching processes it is desired to have vertical walls resulting. An exception to this is in the case of via holes, where it is now recognized that it is advantageous to have sloping sidewalls. The article by Bondur and Clark in Solid State Technology, page 122, April 1980, describes a process for obtaining via holes with sloping sidewalls in $SiO_2$ layers; EP-A-0 010 657 discloses oxygen plasma etching of via holes in a polymer film using a deposited and patterned silicon film as a mask.

The invention seeks to provide a process for forming via holes having sloping sidewalls in a polymer film, which is more convenient than conventional processes involving wet development with alkaline solutions.

A process for forming via holes having sloping sidewalls in a polymer film comprises, according to the invention, the successive steps of coating a substrate with a polymer film, positioning a perforated mask at a distance of from 20 to 200 micrometers above the polymer film, the mask being formed of a material which is impervious to oxygen reactive ion etching; and exposing the polymer film to oxygen reactive ion etching through the mask until holes are etched through the polymer film in registration with the perforations in the mask.

Any suitable organic polymer may be used to form the film used in the present process. Many such materials are known, for example, those used as resist materials. Particularly good results have been obtained when the organic film is a polyimide.

The mask may be of any material impervious to oxygen reactive ion etching. One such preferred material is silicon, particularly silicon (100) such as is found in stencil masks. The mask thickness is not critical, but good results have been obtained with masks of from about 2 to 5 micrometers in thickness.

Control of the gap between the polymer film and the mask is a critical feature of the present invention. As this gap is increased, the slope of the wall becomes greater. Conversely, as it is decreased, the slope becomes less. As is shown in the control experiment below, when there is no gap at all, that is, when the mask is in contact with the polymer film, sloping sidewalls are not obtained at all. Under these circumstances the sidewalls are vertical. The most preferred distance between the mask and the polymer film is from 50 to 100 micrometers.

The following experiments demonstrate the process for carrying out the present invention. In the first experiment, the mask is in contact with the polymer film, i.e., the gap is zero and under these circumstances a vertical sidewall results. Examples 1, 2 and 3 below show the operation of the present invention to obtain the desired sloping sidewalls. The experiments were all conducted using silicon (100) stencil masks.

Control
Zero gap with an oxygen etch barrier:
RIE conditions
$O_2$ at a pressure of 2 Pascals (0.15 Torr)
10 sccm
- 300 Volt bias potential
Substrate temperature 65°C
Result: vertical sidewalls for polylmide patterns.

Example I
200μm gap between a stencil mask and polyimide film
$O_2$ at a pressure of 2 Pascals (0.15 Torr)
10 sccm
- 300 Volt bias potential
Substrate temperature 65°C
Result: 35° sidewall angle for polyimide patterns.

Example II
40μm gap between a stencil mask and polyimide film
$O_2$ at a pressure of 8 Pascals (0.06 Torr)
4.2 sccm
- 500 Volt bias potential
Substrate temperature 65°C
Result: 60° sidewall angle for polyimide patterns.

EXAMPLE III
200μm gap between a stencil mask and polyimide film
$O_2$ at a pressure of 8 Pascals (0.06 Torr)
4.2 sccm
- 475 Volt bias potential
Substrate temperature 65°C
Result: 40° sidewall angle for polyimide patterns.

## Claims

1. A process for forming via holes having sloping sidewalls in a polymer film, comprising the successive steps of:

   coating a substrate with a polymer film, positioning a perforated mask at a distance of from 20 to 200 micrometers above the polymer film, the mask being formed of a material which is impervious to oxygen reactive ion etching; and exposing the polymer film to oxygen reactive ion etching through the mask until holes are etched through the polymer film in registration with the perforations in the mask.

2. A process as claimed in claim 1, wherein the distance between the polymer film and the mask is from 50 to 100 micrometers.

3. A process as claimed in claim 1 or claim 2, wherein the polymer film is a polyimide film.

4. A process as claimed in any preceding claim, wherein the mask is made of silicon.

5. A process as claimed in any preceding claim, wherein the mask is from 2 to 5 micrometers thick.

6. A process as claimed in any preceding claim, wherein the perforations in the mask are from 1 to 15 micrometers in diameter.

## Revendications

1. Procédé pour former des trous de contact ayant des parois latérales obliques dans une couche en polymère, caractérisé en ce qu'il comprend les phases successives de: revêtement d'un substrat au moyen d'une couche en polymère, mise en place d'un masque perforé au-dessus de la couche polymère, à une distance de 20 à 200 $\mu$m, le masque étant formé d'un matériau qui est résistant à la corrosion ionique réactive à l'oxygène, et exposition de la couche polymère à un traitement de corrosion ionique réactive à l'oxygène à travers le masque, jusqu'à ce que des trous soient formés à travers la couche polymère, qui coïncident avec les perforations du masque.

2. Procédé selon la revendication 1, caractérisé en ce que la distance entre la couche polymère et le masque est de 50 à 100 $\mu$m.

3. Procédé selon la revendication 1 ou 2, caractérisé en ce que la couche polymère est une couche en polyimide.

4. Procédé selon l'une quelconque des revendications précédentes, caractérisé en ce que le masque est fabriqué en silicium.

5. Procédé selon l'une quelconque des revendications précédentes, caractérisé en ce que le masque a une épaisseur de 2 à 5 $\mu$m.

6. Procédé selon l'une quelconque des revendications précédentes, caractérisé en ce que les perforations du masque ont un diamètre de 1 à 15 $\mu$m.

## Ansprüche

1. verfahren zur Herstellung von Durchgangslöchern mit abgeschrägten Seitenwänden in einem Polymerfilm, dadurch **gekennzeichnet,** daß es die aufeinanderfolgenden Stufen umfaßt:

Beschichten eines Substrats mit einem Polymerfilm

Positionieren einer perforierten Abdeckblende in einer Entfernung von 20 bis 200 $\mu$m über dem Polymerfilm, wobei die Abdeckblende aus einem Material gebildet ist, das gegenüber sauerstoffreaktivem Ionenätzen undurchdringlich ist, und

Exponieren des Polymerfilms gegenüber einem sauerstoffreaktiven Ionenätzen durch die Abdeckblende bis Löcher durch den polymerfilm gemäß den Perforationen in der Abdeckblende geätzt sind.

2. verfahren nach Anspruch 1, dadurch **gekennzeichnet,** daß die Entfernung zwischen dem Polymerfilm und der Abdeckblende von 50 bis 100 $\mu$m beträgt.

3. verfahren nach Anspruch 1 oder 2, dadurch **gekennzeichnet,** daß der Polymerfilm ein Polyimidfilm ist.

4. verfahren nach einem der vorausgehenden Ansprüche, dadurch **gekennzeichnet,** daß die Abdeckblende aus Silicium ist.

5. Verfahren nach einem der vorausgehenden Ansprüche, dadurch **gekennzeichnet,** daß die Abdeckblende von 2 bis 5 $\mu$m dick ist.

6. Verfahren nach einem der vorausgehenden Ansprüche, dadurch **gekennzeichnet,** daß die perforationen in der Abdeckblende einen Durchmesser von 1 bis 15 $\mu$m besitzen.